# EUROPÄISCHE PATENTANMELDUNG

(11) **EP 1 826 812 A1**
(43) Veröffentlichungstag der Anmeldung: **29.08.2007**
(21) Anmeldenummer: 07003513.4
(22) Anmeldetag: 21.02.2007
(51) Int. Cl.: H01L 21/00, G01V 8/20

(54) **Verfahren und Vorrichtung zum Aufnehmen und/oder Transportieren von Substraten**

(30) Priorität: 23.02.2006 DE 102006008997
(71) Anmelder: Integrated Dynamics Engineering GmbH, 65479 Raunheim (DE)
(72) Erfinder: Tillmann, Ralf, 68309 Mannheim (DE); Maas, Hans-Jürgen, 55286 Wörrstadt (DE); Weiske, Ingo, 60316 Frankfurt am Main (DE); Kraus, Martin, 64572 Büttelborn (DE)
(74) Vertreter: Herden, Andreas F.

(57) **Zusammenfassung**

Die Erfindung betrifft ein Verfahren zum Aufnehmen und/oder Transportieren von Substraten, wobei über zumindest einen Sensor eine Abweichung der Position eines Substrats, insbesondere eines in einem Slot eines Behälters angeordeten Substrats, zumindest in Bezug auf einen Freiheitsgrad erfasst wird und unter Einbeziehung dieser Abweichung ein Bewegungsverlauf zumindest einer Aufnahmeeinrichtung und/oder Transporteinrichtung bestimmt wird.

## Beschreibung

### Gebiet der Erfindung:

Die Erfindung betrifft ein Verfahren und eine Vorrichtung zum Aufnehmen und Transportieren von Substraten, insbesondere von Wafern in der Halbleiterindustrie.

### Hintergrund der Erfindung:

In Fertigungsprozessen der Halbleiterindustrie werden typischerweise Reproduktionsverfahren eingesetzt, bei denen verschiedene Vorlagen und Substrate verwendet werden. Als Vorlagen dienen dabei sowohl Masken, die in einem lithografischen Prozess verwendet werden, als auch Stempel für Stempelverfahren. Darüber hinaus gibt es Beschreibungsprozesse, bei denen direkt auf die Substrate geschrieben wird (EBeam). Bei den Substraten handelt es sich in der Produktion von Halbleitern im allgemeinen um dünne Scheiben (derzeit bis 300mm Durchmesser und weniger als 1 mm Dicke), die aus unterschiedlichsten Halbleiter-Materialien hergestellt werden. Die derzeit am häufigsten verwendeten Masken werden aus quadratischen Quartzglasskuben (6 Zoll Seitenlänge) von bis zu ¼ Zoll Dicke hergestellt. Auch Vorlagen werden in den nachfolgend beschriebenen Verfahren aus Darstellungsgründen als Substrate bezeichnet.

Innerhalb der gesamten Fertigungskette müssen die Halbleiter-Substrate für ihren Transport und für die Einbringung in die unterschiedlichen Herstellungs-, Prozess-, und Messanlagen sicher und möglichst sauber in verschlossenen Behältern aufbewahrt werden. Diese Behälter werden als Kassetten bzw. Horden bezeichnet. Typisch sind hier unter den Bezeichnungen SMIF, FOUP, FOSB, Open Cassette, etc. verwendete Substratablagen, bei denen bis zu 25 Substrate in definiertem Abstand, der als Pitch bezeichnet wird, übereinander angeordnet sein können. Über die Jahre haben sich unterschiedlichste Modelle, Typen und Standards von Horden und Kassetten entwickelt, die alle Variationen in ihrer Geometrie zeigen. Entscheidend ist auch, dass jede individuelle Horde oder Kassette schon aufgrund der Fertigung Toleranzen zum Referenzdesign aufweisen kann. Aus diesen Gründen können im Vergleich über alle Hordentypen hinweg sich die Position der Substrate teilweise drastisch unterscheiden (um mehr als einen Pitch in der Höhe). Zusätzlich können sich die Substrate durch den Öffnungsprozess des Behälters oder durch Einwirken auf die Behälter, auch nach deren Öffnung, in den Behältern verschieben.

Eine Anforderung an die Automatisierungstechnik in der Halbleiterfertigung ist es, die Substrate aus den Behältern herauszuholen und einzubringen. Die Anforderungen bezüglich Zuverlässigkeit und Stressfreiheit für die Substrate bei ihrer Übergabe von Behälter zu Anlage steigen dabei fortlaufend. Aus diesem Grund ist eine möglichst genaue Ansteuerung des Übergabepunktes erforderlich. Der Übergabepunkt selbst wird in der Automatisierungstechnik allgemein durch sogenannte Teachprozesse einmalig vermittelt. Bei Behältern, die mehr als ein Substrat aufnehmen, wird dabei ebenfalls nur eine Position eingelernt und die Positionen der darüber angeordneten Substrate über Verschiebevektoren postuliert (typischerweise wird über den Pitch die Position der einzelnen Substrate abgeleitet). Vor dem Zugriff wird das Vorhandensein eines Substrates im Allgemeinen über kontaktfreie Sensoren bestimmt.

Der Einfluß der oben beschriebenen Toleranzen auf die Position der Substrate bei gleichen Hordentypen einerseits wird durch einen entsprechend ausreichenden Fangbereich des Automatisierungsprozesses abgedeckt. Sollen Hordentypen mit anderen Designdaten andererseits eingesetzt werden, muss der damit verbundene Übergabepunkt neu eingelernt werden.

Dieses Vorgehen hat zwei wesentliche Nachteile. Erstens führt der vergrößerte Fangbereich zu Zeitverlust und evtl. zu vermehrter Relativbewegung am erwarteten Übergabepunkt, wodurch Stress, Schädigungen bzw. Kontaminationen am Substrat verstärkt auftreten können. Zweitens führt das Einlernen von Übergabepunkten bei Einsatz von anderen Hordentypen ebenfalls zu einem aufwendigen und zeitintensiven Umgang im Automatisierungsprozess.

### Aufgabe der Erfindung

Der Erfindung liegt demgegenüber die Aufgabe zugrunde, die vorstehend beschriebenen Nachteile im Stand der Technik zu veringern und die Aufnahme und den Transport von Substraten, insbesondere Wafern, zu verbessern.

Die Flexibilität des Automatisierungsprozesses für unterschiedliche Behälter soll gemäß einer weiteren Aufgabe der Erfindung erhöht werden.

Eine weitere Aufgabe der Erfindung ist die Reduzierung von Toleranzproblemen an der Übergabeposition und deren Folgen, die durch Unterschiede bei verschiedenen Behältertypen (designspezifisch), Abweichungen bei individuellen Behälters (individuell behälterspezifisch), Abweichungen der Sollposition für die individuellen Slots innerhalb eines Behälters (individuell slotspezifisch), Veränderungen der Substratposition durch äußere Einwirkungen (Öffnungsprozess des Behälters, Stöße an die Behälter, etc.) (individuell slotspezifisch) und Veränderungen der Position benachbarter Substrate, die sich nachteilig auf den Prozess auswirken können (individuell slotumgebungsspezifisch), verursacht werden können.

Eine weitere Aufgabe der Erfindung ist, den Zeitverlust bei der Einrichtung und Instandhaltung der Anlagen zu reduzieren.

Nach einer weiteren Aufgabe der Erfindung soll die Prozesszeit für die Automatisierungsschritte reduziert werden.

### Zusammenfassung der Erfindung

Die Aufgabe der Erfindung wird bereits durch ein Verfahren zum Aufnehmen und Transportieren von Substraten, sowie durch eine Vorrichtung zum Aufnehmen und Transportieren von Substraten gemäß einem der unabhängigen Ansprüche gelöst.

Bevorzugte Ausführungsformen und Weiterbildung der Erfindung sind den jeweiligen Unteransprüchen zu entnehmen.

Danach ist ein Verfahren zum Aufnehmen und/oder Transportieren von Substraten vorgesehen, wobei über zumindest einen Sensor eine Position eines Substrats, insbesondere eines in einem Slot eines Behälters angeordneten Substrats, zumindest in Bezug auf einen Freiheitsgrad erfasst wird.

Unter der Erfassung der Position eines Substrats wird im Sinne der Erfindung sowohl die Erfassung einer Absolutposition, als auch die Erfassung einer Relativposition, etwa in Bezug auf andere Bauteile einer Anlage innerhalb der das erfindungsgemäße Verfahren verwendet wird, verstanden.

Unter Einbeziehung der Position des Substrats wird ein Bewegungsablauf der Aufnahme- und Transporteinrichtung bestimmt.

Durch die Positionserfassung wird ermöglicht, ej,n wesentlich genaueres Handling der Aufnahme- und Transporteinrichtung durchführen zu können. So wird die Aufnahmeeinrichtung wesentlich genauer geführt und die Anlage kann sich unterschiedlichen Konfigurationen und Randbedingungen, insbesondere unterschiedlichen Behältertypen und unterschiedlichen Substraten, anpassen.

Gemäß einer bevorzugten Ausführungsform der Erfindung wird über den zumindest einen Sensor die Relativposition des Substrates zu einer Aufnahmeeinrichtung bestimmt. Es hat sich herausgestellt, dass insbesondere über die Bestimmung des Abstandes der Aufnahmeeinrichtung zu dem Substrat eine exakte Positionierung ermöglicht wird.

Gemäß einer weiteren bevorzugten Ausführungsform der Erfindung wird über zumindest einen Sensor die Belegung einer Substratablage bestimmt. Die Belegung einer Substratablage (Horde) ist ein variabler anlagenspezifischer Parameter, dessen Beachtung bei der Feineinstellung des Bewegungsverlaufs eine wesentlich genauere Führung der Aufnahmeeinrichtung ermöglicht. So haben Veränderungen der Belegung, etwa leere Slots, Auswirkungen auf die gesamte Substratablage und damit auch auf die in der Substratablage verbliebenen Substrate.

Bei einer Weiterbildung der Erfindung wird eine Position des Substrats und/oder die Belegung einer Substratablage über zumindest einen an einer Aufnahmeeinrichtung angeordneten Sensor bestimmt.

Die Erfinder haben herausgefunden, dass es in einer an sich bekannten Automatisierungseinrichtung möglich ist, mit an der Aufnahmeeinrichtung angeordneten Sensoren, sowohl die Position der Substrate zu bestimmen, insbesondere die Relativposition zur Aufnahmeeinrichtung, als auch zu bestimmen, ob die Slots einer Substratablage (Horde) jeweils bewegt sind.

Dazu fährt die Aufnahmeeinrichtung einen im Wesentlichen vorgegebenen Bewegungsverlauf, wie dies auch bei aus dem Stand der Technik bekannten Anlagen, welche nicht über entsprechende Sensoren verfügen, der Fall ist.

Über den oder die Sensoren wird eine exakte Relativposition des Substrats gegenüber der Aufnahmeeinrichtung ermittelt.

Diese Position kann dann in weiteren Bewegungsverläufen berücksichtigt werden, um den Bewegungsverlauf genauer einzustellen.

Bei einer weiteren bevorzugten Ausführungsform der Erfindung werden sich auf Positionsänderungen beziehende Kenndaten gespeichert und der Bewegungsverlauf der Aufnahmeeinrichtung unter Einbeziehung dieser Kenndaten, bestimmt.

Insbesondere ist vorgesehen, einen Kenndatensatz aufzunehmen und zu speichern, welcher sich auf bestimmte Anlagenkonfigurationen bezieht. Dabei können mit einer Anlage unter verschiedenen Konfigurationen, etwa bei unterschiedlicher Besetzung einer Substratablage oder bei verschiedenen Substratablagen und unterschiedlichen Substraten, Lerndurchläufe gefahren werden, mit welchen der Bewegungsverlauf der Aufnahmeeinrichtung feinjustiert werden kann.

Diese Kenndaten werden dann in Form von Datensätzen in einer Automatisierungseinrichtung unterlegt. Je nach aktueller Konfiguration der Anlage wird der Bewegungsverlauf der Aufnahme- und Transporteinrichtung dann, unter Einbeziehung des Kenndatensatzes, feinjustiert, ohne dass eine laufende Anpassung des Bewegungsablaufs nötig ist.

Bei einer Weiterbildung der Erfindung kann der Bewegungsverlauf auch laufend oder in Intervallen geänderten Anlagenkonfigurationen angepasst werden. Vorteilhafterweise fährt eine Automatisierungseinrichtung einen Lerndurchlauf, bei welchem die Aufnahme- und Transporteinrichtung entlang einer vorgegebenen Bewegungsrichtung, beispielsweise die Slots einer Substratablage, abfährt. Kenndaten der zu diesen Zeitpunkt vorliegenden Anlagenkonfiguration werden gespeichert. Während des Betriebs kann sich dann die Automatisierungseinrichtung anpassen, wenn sich beispielsweise durch Entnahme von Substraten die genaue Position von anderen Substraten, die sich beispielsweise ober- oder unterhalb des Slots befinden, ändert.

Die Anlage lernt so Änderungen des Bewegungsverlaufs, welche mit Änderungen der Anlagenkonfiguration korrelieren.

Vorteilhafterweise wird bei der Bestimmung des Bewegungsverlauf der Aufnahmeeinrichtung sowohl die Belegung eines Behälters zur Substratablage, insbesondere die Belegung der einzelnen Slots, und die Art des zu bewegenden Substrats, berücksichtigt.

Bei einer vorteilhaften Ausführungsform der Erfindung wird die Position des Substrats, insbesondere die Relativposition zur Aufnahmeeinrichtung in drei Translationsrichtungen und in mindestens zwei Rotationseinrichtungen, erfasst. So ist bei einem runden Wafer eine genaue Positionsbestimmung möglich. Solange der Wafer noch nicht bearbeitet ist, reicht aufgrund der Rotationssymetrie eine Bestimmung der Position in zwei Rotationsrichtungen.

Bei einer bevorzugten Ausführungsform der Erfindung wird die Position über zumindest zwei an der Aufnahmeeinrichtung angeordnete Sensoren erfasst. Derartige Sensoren, beispielsweise ausgestaltet als kapazitive Abstandssensoren, ermöglichen, sofern sie in einem definierten Abstand voneinander angeordnet sind, die genaue Bestimmung der Relativposition des Wafers zur Aufnahmeeinrichtung.

Insbesondere ist vorgesehen, mehrere Sensoren auf der Aufnahmeeinrichtung zu positionieren. Über ein derartiges Sensorenfeld, welches sich randseitig über das Substrat erstreckt, kann, da nicht alle Sensoren vom Wafer abgedeckt werden, die genaue Position des Wafers bezüglich der Waferebene zur Aufnahmeeinrichtung erfasst werden.

Die Erfindung betrifft des Weiteren eine Vorrichtung zum Aufnehmen und Transportieren von Substraten, welche zumindest einen Sensor zur Erfassung der Position eines Substrats zumindest in Bezug auf einen Freiheitsgrad aufweist, insbesondere eines in einem Slot eines Behälters (Horde) angeordneten Substrats.

Weiter weist die Vorrichtung Mittel zum Steuern des Bewegungsverlaufs einer Aufnahme- und Transporteinrichtung auf. Bei diesen Steuerungsmitteln handelt es sich insbesondere um Teile einer Automatisierungseinrichtung. Gemäß der Erfindung umfassen diese Mittel zum Steuern des Bewegungsverlaufs Mittel zur Einbeziehung der erfassten Positionen des Substrats.

Vorzugsweise werden konfigurationsspezifische Bewegungsabläufe aufgenommen und in Form eines Kenndatensatzes, welcher den jeweiligen konfigurationsspezifischen Bewegungsablauf reprasentiert, gespeichert. Mit Hilfe derartiger Kenndatensätze ist eine wesentlich genauere Positionierung der Aufnahmeeinrichtung möglich.

Ein derartiger Kenndatensatz repräsentiert insbesondere Veränderungen des Bewegungsablaufes, die von einer Änderung der Anlagenkonfiguration abhängig sind.

Im Sinne der Erfindung können derartige Kenndatensätze sowohl den gesamten Bewegungsablauf umfassen, also Teile des Datensatzes zur Steuerung der Automatisierungseinrichtung sein, als auch lediglich die Feinsteuerung einer Automatisierungseinrichtung repräsentieren. Gemäß der zweiten Alternative müssen nicht komplette Bewegungsabläufe mit den zugehörigen Datenmengen aufgenommen und gespeichert werden, vielmehr können diese Bewegungsverläufe, die den grundsätzlichen den Betrieb der Anlage repräsentieren, belassen werden. Die Kenndatensätze im Sinne der Erfindung dienen dann lediglich der Feinsteuerung des Bewegungsverlaufs.

Die Aufnahmeeinrichtung weist zur Erfassung der Relativposition eines Substrats bei einer besonderen Ausführungsform der Erfindung zumindest drei, vorzugsweise vier und besonders bevorzugt fünf Sensoren auf, mit denen eine genaue Bestimmung der Relativposition möglich ist.

Zusätzlich kann beispielsweise zur Höhenbestimmung der Aufnahmeeinrichtung (2-Achse) eine oder mehrere Lichtschranken vorgesehen sein.

Das Verfahren kann sich im Detail wie folgt darstellen.

Für den Prozessablauf wird zunächst ein Parametersatz für eine gegebene Station durch das Teachen einer zur Referenz definierten Position des Substrates ermittelt (Teachposition).

Sodann werden Designdaten von anderen Behältern, die deren Unterschied zu der Teachposition beschreiben, ermittelt und in einer Datenbank zur weiteren Nutzung hinterlegt.

In einem nächsten Schritt erhält die Handlersteuerung, die den Bewegungsverlauf steuert, die Information, welcher Hordentyp im Prozess aufgestellt wurde. Die mit diesem Typ hinterlegten Designdaten werden genutzt, um die Teachposition entsprechend zu verschieben und einen korrigierten Stationsparametersatz zu ermitteln. Mit diesem veränderten Datensatz wird die durchzuführende Messfahrt abgeleitet und angestossen. Als Resultat der Messfahrt ergeben sich die Substratpositionen in allen durch den Umfang der eingesetzten Sensorik definierten Freiheitsgraden.

Aus diesen Daten können nun verschiedene Korrekturen für unterschiedliche Prozessfälle abgeleitet werden
- Die Mittelwerte der einzelnen Freiheitsgrade Können benutzt werden, um die Designdaten verfeinert zu korrigieren. Stehen die Designdaten zu diesem Zeitpunkt nicht zur Verfügung, können die Mittelwerte allein zur Korrektur der Teachposition genutzt werden. Substratspezifische Eigenschaften, wie Verbiegung, Wölbung etc. wie sie z.B. bei sehr dünnen Substraten auftreten, können zur Korrektur mitberücksichtigt werden. Die Grunddaten wie die Belegung der Slots und die behälterspezifischen Daten zur grundsätzlichen Trajektorienplanung (Planung des Bewegungsverlaufs) können nun festgelegt werden und ebenfalls zur Überprüfung herangezogen werden, ob nicht korrigierbare oder unerwünschte Fehlpositionen der Substrate oder des ganzen Behälters vorliegen.
- Mit der Berechnung eines lokalen Umgebungswertes oder Mittelwertes der einzelnen Freiheitsgrade wird die Trajektorienplanung für einen individuellen Slot auch von dessen direkten Nachbarn abhängig gemacht. Einflüsse von Positionsabweichungen benachbarter Slots auf das Einbringen oder Abholen eines individuellen Substrates können damit ermittelt werden und zur Korrektur oder zur generellen Überprüfung auf Machbarkeit herangezogen werden.
- Slotspezifische Korrektur der einzelnen Freiheitsgrade: Die Bestimmung der Position eines einzelnen Substrates kann letztlich zur restlichen Korrektur bzw. finalen Festlegung der Trajektorie (Bewegungsverläufe) unter Berücksichtigung der vorstehend genannten Korrekturmöglichkeiten herangezogen werden.

Abhängig davon, welche der vorstehend gelisteten Werte vorliegen, können diese auch auf nicht belegte Slots bei dem Einbringungsprozess des Substrates angewendet werden:
Sollte der gesamte Behälter leer sein, können die Design-Daten verwendet werden.
Ist ein Behälter teilbelegt, kann der Mittelwert: zur Feinkorrektur herangezogen werden.
Die behältnisspezifischen Messwerte können bei der Wiederverwendung der Behälter, die durch Nummern, Barcodes oder andere Tags individuell gekennzeichnet sind, für zukünftige Korrekturen als Datensatz hinterlegt und von entsprechend ausgestatteten Anlagen herangezogen werden.

Durch das Verfahren wird somit ein Entleeren und ein Befüllen mit individueller Trajektorienplanung möglich und der Bewegungsverlauf ist selbst auf Substrateigenschaften anpassbar.

Bei Auswahl von geeigneten Sensoren können diese noch zusätzlich zur Online-Korrektur des Bewegungsverlaufs benutzt werden. Da diese im Allgemeinen so ausgelegt werden, dass sie nur beim Annähern an ein Substrat sinnvolle Werte liefern, sollten diese auf die individuell festgelegten Daten wirken und nicht auf die hordenspezifischen Werte.

Das Verfahren umfasst die Detektierung, Verarbeitung, Anwendung und Verwaltung von designspezifischen, individuellen behältnisspezifischen und individuellen slotspezifischen Positionsdaten von Substraten in Behältern für die Halbleiterindustrie zur optimierten Trajektorienplanung der Automatisierungstechnik mit dem Zweck der Steigerung der Prozesssicherheit und Minimierung des Einflusses des Handlings auf die Substrate während des Handlings in oder aus dem Behältnis.

Als Sensorik am Handlingsystem, welches die Aufnahmeeinrichtung umfasst und Teil einer Automatisierungseinrichtung ist, können insbesondere folgende Sensoren eingesetzt werden:
- Abstandssensoren, insbesondere kapazitive Sensoren an der Übergabemimik in z-Richtung (vertikal) orientiert zur Positionsbestimmung von Höhen und Winkeln.
   Bei nicht rotationssymetrischen Substraten wie Masken sind dabei 6 Freiheitsgrade, bei rotationssymmetrischen Substraten (Wafer) 5 Freiheitsgrade erzielbar. Für einen möglichst schnellen Prozess kann dabei eine Z-Vorbestimmung (Vertikalachse) eingesetzt werden, die bspw, durch einen optischen Sensor geleistet werden kann, der am Substrathandler oder an der behältnisaufnehmenden Komponente montiert ist. Die kapazitiven sensoren können auch für eine Online-Korrektur genutzt werden.
- Ein Lichtstrahl, der unterbrochen wird, kann benutzt werden, um Abstands- und Höheninformationen zu ermitteln.
- Hochauflösende Abstandssensoren, z.B. Ultraschallsensoren in r-Richtung orientiert für 5 bzw. 4 Freiheitsgrade. Dieser Aufbau ergibt die einfachste Messfahrt.

Mit dem Verfahren können mit nur einer Messfahrt: alle wesentlichen Werte bestimmt werden, um die optimale Trajektorenplanung zur besten Ubergabeposition zu ermöglichen. Das Verfahren ermöglicht die Vermessung von Bewegungsprofilen zwischen Nachbarn sowie die Annäherung zur optimierten Übergabepositionen.

Daraus ergeben sich präzisere Übergabepositioner, höhere Prozesssicherheit, kürzere Trajektorienzeiten, verringerte Beschädigungen (Kratzer, Kontamination, Erschütterungen etc.) sowohl beim Befüllen als auch beim Endleeren des Behälters, beziehungsweise der Substratablage.

Die in diesem Verfahren ermittelte optimierte Trajektorie wird stufenweise erzeugt auf Basis von Designdaten, individuellen behältnisspezifischen, individuellen Slotumgebungs- und individuellen slotspezifischen Daten.

Durch die Reduzierung auf eine Messfahrt wird der damit verbundene Zeitverlust begrenzt. Die Optimierung der Trajektorien kann im Gesamtprozess auch zu einer Zeitersparnis führen.

Mit diesem Verfahren können Design-Daten, Chargendaten oder Individualdaten ermittelt, verwaltet und permanent kontrolliert werden.

Das Verfahren erlaubt eine Kontrolle der Behälterdaten und ermöglicht so die kontinuierliche Überwachung des Behälters auf Veränderung durch Zeit und Gebrauch.

Die Verwendung von Designdaten und/oder die Abweichungen von der Referenz reduziert den Teachvorgang auf einen einzigen Prozess und erlaubt die Verwendung unterschiedlichster Typen und Modelle ohne zusätzlichen Teach-Aufwand.

Das Verfahren erlaubt sowohl die manuelle als auch die automatisierte Übergabe der Daten und deren Zuordnung zu individuellen Behältern. Die Daten können auch in anderen Systemen genutzt werden. Durch Überwachung der Daten können Fehlplazierungen des Behälters frühzeitig detektiert werden, wodurch die Bedien-, und Prozesssicherheit nochmals erhöht wird.

### Kurzbeschreibung der Zeichnungen

Die Erfindung soll im Folgen anhand der Zeichnungen Fig. 1 bis Fig. 3 näher erläutert werden.
- Fig. 1: zeigt schematisch eine erfindungsgemäße Aufnahmeeinrichtung,
- Fig. 2: zeigt schematisch eine Substratablage Horde),
- Fig. 3: zeigt schematisch ein Fließbild eines Ausführungsbeispiels der erfindungsgemäßen Verfahrensdurchführung.

### Detaillierte Beschreibung der Zeichnungen

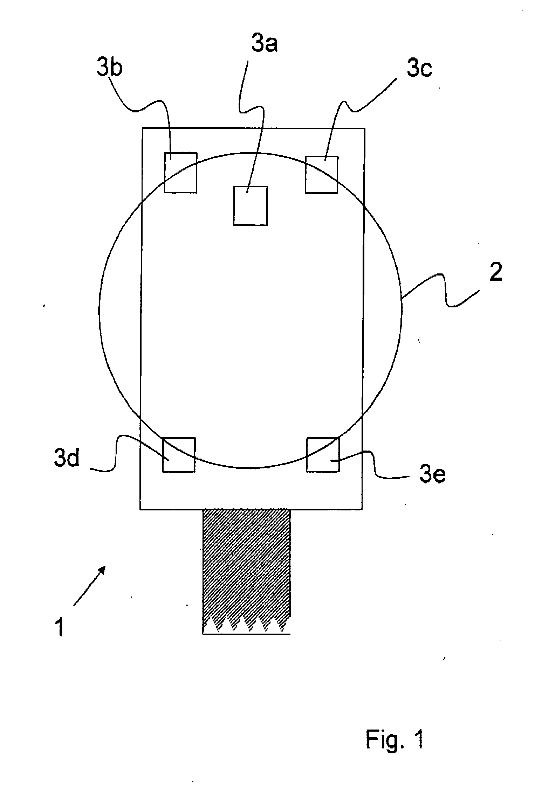

Fig. 1 zeigt schematisch eine erfindungsgemäße Aufnahmeeinrichtung 1. Die Aufnahmeeinrichtung 1 ist zur Aufnahme eines Substrates 2 ausgebildet, welches hier schematisch in Form eines kreisförmigen Wafers dargestellt ist. Die Aufnahme des Substrats 5 kann beispielsweise elektrostatisch erfolgen. Die Aufnahmeeinrichtung 1 ist an eine Automatisierungsanlage angeschlossen (nicht dargestellt) und dient der Aufnahme und dem Transport von Substraten 2.

Zur Messung der Relativposition des Substrats 2 gegenüber der Aufnahmeeinrichtung 1 sind auf der Aufnahmeeinrichtung insgesamt 5 Sensoren 3a-3e vorgesehen. Die Sensoren 3a-3e sind als kapazitiv messende Abstandssensoren ausgebildet.

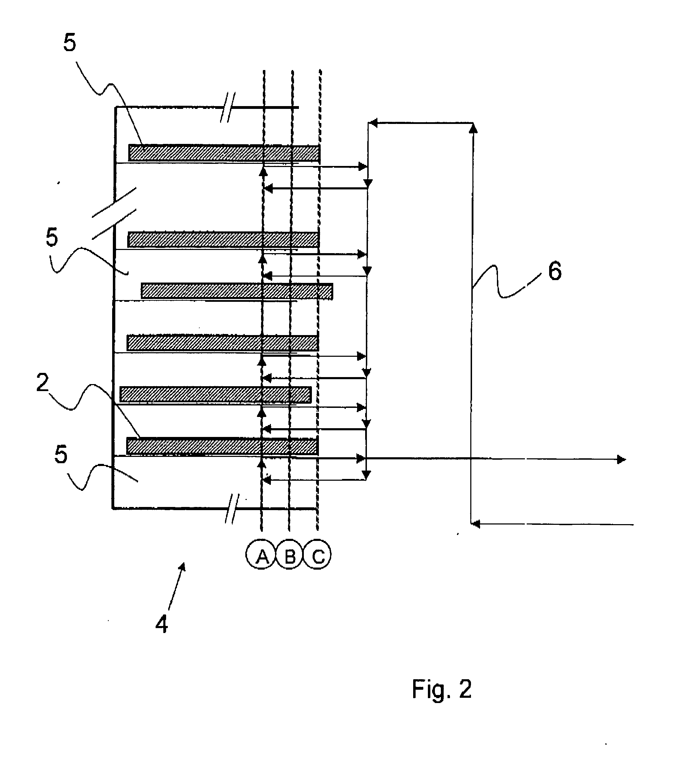

Durch Vergleich der Messdaten der Sensoren 3a bis 3c wird eine Bestimmung der Relativposition in alle drei Translationsrichtungen, sowie eine mögliche Verkippung des Substrates zumindest in zwei Rotationsrichtungen ermöglicht, wie nachfolgend unter Bezugnahme auf Fig. 2 näher erläutert wird.

Bezugnehmend auf Fig. 2 soll schematisch eine Messfahrt zur Datenaufnahme näher erläutert werden.

Fig. 2 zeigt eine Substratablage 4, welche auch als Horde bezeichnet wird. Die Substratablage umfasst mehrere Slots 5, in welchen Substrate 2 abgelegt werden können.

Bei einer Messfahrt wird die Aufnahmeeinrichtung (nicht dargestellt) zunächst in Z-Richtung, welche mit einem Pfeil 6 markiert ist, hochgefahren, um eine Vorbestimmung der Z-Achse durchführen zu können.

Sodann erfolgt eine Messfahrt, bei welcher zur Bestimmung der relevanten Daten mit Hilfe der in Fig. 1 dargestellten kapazitiven Sensoren an den Messpunkten, welche mit den gestrichelten Linien A, B und C markiert sind, Daten der Sensoren aufgenommen. Dabei werden die einzelnen Slots 5 von der Substrataufnahme abgefahren.

In Stellung A ist mindestens einer der Sensoren 3a bis 3c aus Fig. 1 durch das Substrat vollständig abgedeckt. Ein Vergleich der gemessenen Abstände der Sensoren 3a bis 3c ermöglicht die Bestimmung der Höhe des Substrates und seiner möglichen Verkippung um die Längsachse der Aufnahmeeinrichtung.

In Stellung B sind die Sensoren 3a bis 3c vollständig durch das Substrat abgedeckt. Durch einen Vergleich der Abstandswerte zwischen Messpunkt A und B kann eine mögliche Verkippung entlang der Querachse der Aufnahmeeinrichtung bestimmt werden.

Über die Bewegung zu Position C kann eine Randbestimmung erfolgen, über die die Position des Substrates in den übrigen translatorischen Richtungen bestimmt werden kann.

Mittels der durch die Sensoren gewonnen Messdaten kann zum einen ein Kenndatensatz hinterlegt werden, welcher beispielsweise die Feinkorrektur des Bewegungsverlaufs bei verschiedenen Anlagenkonfigurationen, insbesondere bei verschiedenen Belegungen der Substratablage 4 ermöglicht. Neben einer Feineinstellung des Bewegungsverlaufs der Aufnahmeeinrichtung bei einer Lernfahrt kann auch während des Anlagenbetriebs laufend entweder unter Hinzuziehung weiterer Kenndaten, die bei weiteren Messfahrten gewonnen werden und/oder unter laufender Berücksichtigung der Sensormesswerte der Bewegungsverlauf weiter korrigiert werden.

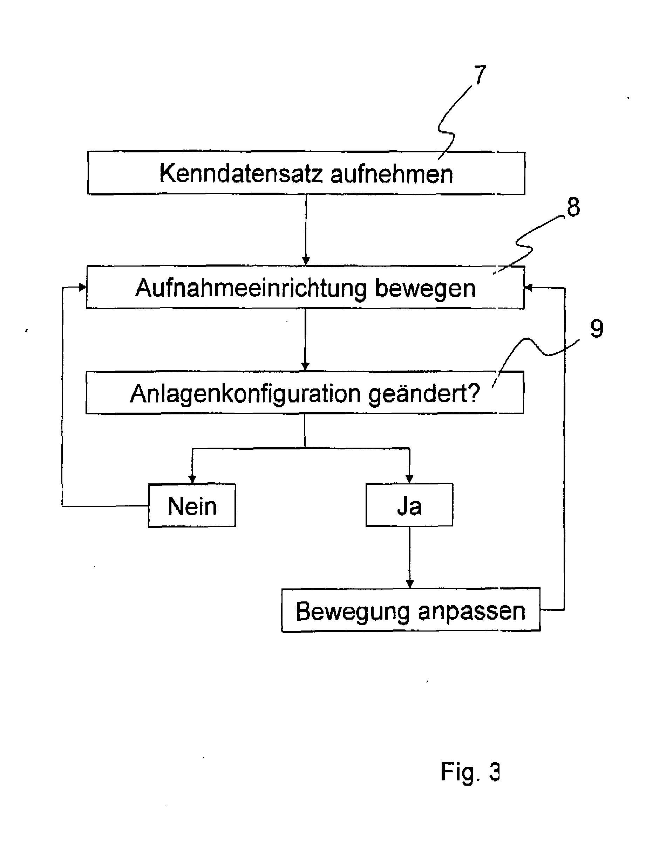

Fig. 3 zeigt schematisch ein Fließbild der wesentlichen Verfahrensschritte einer Ausführungsform des erfindungsgemäßen Verfahrens.

Zunächst werden in einer Lernfahrt einer oder mehrere Kenndatensätze aufgenommen 7.

Die in der Automatisierungseinrichtung (nicht dargestellt) integrierte Aufnahmevorrichtung kann nun zur Durchführung von Produktionsschritten bewegt werden 8. Nach einem Bewegungsverlauf beispielsweise nach der Aufnahme und Weitergabe eines Substrats wird geprüft, ob sich die Anlagenkonfiguration geändert hat 9. Beispielsweise kann anhand eines Strichcodes auf einer Substratablage bestimmt werden, ob eine neue Substratablage in die Anlage eingesetzt wurde. Falls die Anlagenkonfiguration nicht geändert wird, springt das Verfahren zurück auf den Schritt Aufnahmevorrichtung bewegen 8. Die Aufnahmeeinrichtung wird so bewegt, wie es dem vorhandenen Kenndatensatz entspricht.

Falls sich die Anlagenkonfiguration geändert hat, wird durch Einlesen eines neuen gespeicherten Kenndatensatzes die Bewegung der Aufnahmeeinrichtung der geänderten Anlagenkonfiguration angepasst. Dabei repräsentiert der hinterlegte Kenndatensatz die Änderung des Bewegungsablaufs zur Feineinstellung. Gleichzeitig kann laufend über Sensoren der Aufnahmeeinrichtung eine laufende Anpassung vorgenommen werden. Dabei können insbesondere auch neue Kenndatensätze, die geänderten Anlagenkonfigurationen entsprechen, aufgenommen und gespeichert werden.

Es versteht sich, dass vorliegende Erfindung nicht auf eine Kombination vorstehend beschriebener Merkmale beschränkt ist, sondern dass der Fachmann die beschriebenen Merkmale soweit sinnvoll beliebig kombinieren wird.

## Patentansprüche

1. Verfahren zum Aufnehmen und/oder Transportieren von Substraten, wobei über zumindest einen Sensor eine Position eines Substrats, insbesondere eines in einem Slot eines Behälters angeordneten Substrats, zumindest in Bezug auf einen Freiheitsgrad erfasst wird und unter Einbeziehung dieser Position ein Bewegungsverlauf zumindest einer Aufnahmeeinrichtung und/oder Transporteinrichtung bestimmt wird.

2. Verfahren zum Aufnehmen und/oder Transportieren von Substraten nach einem der vorstehenden Ansprüche, **dadurch gekennzeichnet, dass** über den zumindest einen Sensor die Relativposition eines Substrates zu einer Aufnahmeeinrichtung bestimmt wird.

3. Verfahren zum Aufnehmen und/oder Transportieren von Substraten nach einem der vorstehenden Ansprüche, **dadurch gekennzeichnet, dass** über zumindest einen Sensor die Belegung einer Substratablage bestimmt wird.

4. Verfahren zum Aufnehmen und/oder Transportieren von Substraten nach einem der vorstehenden Ansprüche, **dadurch gekennzeichnet, dass** eine Position eines Substrats und/oder die Belegung einer Substratablage, insbesondere eines Slots der Substratablage, über zumindest einen an einer Aufnahmeeinrichtung angeordneten Sensor bestimmt wird.

5. Verfahren zum Aufnehmen und/oder Transportieren von Substraten nach einem der vorstehenden Ansprüche, **dadurch gekennzeichnet, dass** sich auf Positionsänderungen beziehende Kenndaten gespeichert werden und der Bewegungsverlauf der Aufnahmeeinrichtung und/oder Transporteinrichtung unter Einbeziehung dieser Kenndaten bestimmt wird.

6. Verfahren zum Aufnehmen und/oder Transportieren von Substraten nach einem der vorstehenden Ansprüche, **dadurch gekennzeichnet, dass** zumindest ein Kenndatensatz aufgenommen und/oder gespeichert wird, der von einer Änderung der Anlagenkonfiguration, insbesondere einer Änderung der Besetzung einer Substratablage und/oder der Art der verwendeten Substrate abhängige Änderungen des Bewegungsablaufs repräsentiert.

7. Verfahren zum Aufnehmen und/oder Transportieren von Substraten nach einem der vorstehenden Ansprüche, **dadurch gekennzeichnet, dass** über die Bestimmung von Positionsänderungen eine Feineinstellung des Bewegungsverkaufs bestimmt wird.

8. Verfahren zum Aufnehmen und/oder Transportieren von Substraten nach einem der vorstehenden Ansprüche, **dadurch gekennzeichnet, dass** ein Bewegungsverlauf der Aufnahmeeinrichtung und/oder Transporteinrichtung in einem Lerndurchlauf bestimmt wird.

9. Verfahren zum Aufnehmen und/oder Transportieren von Substraten nach einem der vorstehenden Ansprüche, **dadurch gekennzeichnet, dass** der Bewegungsverlauf laufend oder in Intervallen geänderten Anlagekonfigurationen angepasst wird.

10. Verfahren zum Aufnehmen und/oder Transportieren von Substraten nach einem der vorstehenden Ansprüche, **dadurch gekennzeichnet, dass** bei der Bestimmung des Bewegungsverlaufs der Aufnahmeeinrichtung und/oder Transporteinrichtung die Belegung eines Behälters zur Substratablage und/oder die Art eines zu bewegenden Substrats berücksichtigt wird.

11. Verfahren zum Aufnehmen und/oder Transportieren von Substraten nach einem der vorstehenden Ansprüche, **dadurch gekennzeichnet, dass** als Position die Relativposition eines Substrates zur einer Substrataufnahmeeinrichtung bestimmt wird.

12. Verfahren zum Aufnehmen und/oder Transportieren von Substraten nach einem der vorstehenden Ansprüche, **dadurch gekennzeichnet, dass** Anlagen-, insbesondere Behälterspezifische Kenndatensätze in einer Datenbank abgelegt und zur Bestimmung des Bewegungsverlaufs der zumindest einen Aufnahme- und/oder Transporteinrichtung verwendet werden.

13. Verfahren zum Aufnehmen und/oder Transportieren von Substraten nach einem der vorstehenden Ansprüche, **dadurch gekennzeichnet, dass** die Position des Substrats in drei Translationsrichtungen erfasst wird.

14. Verfahren zum Aufnehmen und/oder Transportieren von Substraten nach einem der vorstehenden Ansprüche, **dadurch gekennzeichnet, dass** die Position in zumindest zwei Rotationsrichtungen erfasst wird.

15. Verfahren zum Aufnehmen und/oder Transportieren von Substraten nach einem der vorstehenden Ansprüche, **dadurch gekennzeichnet, dass** die Position über zumindest zwei auf einer Aufnahmeeinrichtung angeordnete Sensoren erfasst wird.

16. Verfahren zum Aufnehmen und/oder Transportieren von Substraten nach dem vorstehenden Anspruch, **dadurch gekennzeichnet, dass** als Sensoren kapazitive Sensoren bereit gestellt werden.

17. Verfahren zum Aufnehmen und/oder Transportieren von Substraten nach dem vorstehenden Anspruch, **dadurch gekennzeichnet, dass** Daten, die zumindest einen Bewegungsvorgang repräsentieren, in einem Speicher gespeichert sind.

18. Vorrichtung zum Aufnehmen und/oder Transportieren von Substraten,
mit zumindest einem Sensor zur Erfassung der Position eines Substrats zumindest in Bezug auf einen Freiheitsgrad, insbesondere eines in einem Slot eines Behälters angeordneten Substrats,
Mitteln zum Steuern des Bewegungsverlaufs einer Aufnahme- und/oder Transporteinrichtung für Substrate,
wobei die Mittel zum Steuern des Bewegungsverlaufs Mittel zur Einbeziehung der erfassten Position des Substrats umfassen.

19. Vorrichtung zum Aufnehmen und/oder Transportieren von Substraten nach einem der vorstehenden Ansprüche, **dadurch gekennzeichnet, dass** die Vorrichtung Mittel zur Aufnahme und/oder Speicherung zumindest eines Kenndatensatzes umfasst, der einen konfigurationsspezifischen Bewegungsablauf repräsentiert.

20. Vorrichtung zum Aufnehmen und/oder Transportieren von Substraten nach einem der vorstehenden Ansprüche, **dadurch gekennzeichnet, dass** die Vorrichtung Mittel zur Anpassung des Bewegungsablaufs abhängig von einer Veränderung der Anlagenkonfiguration, insbesondere der Besetzung einer Substratablage und/oder der Art der verwendeten Substrate aufweist.

21. Vorrichtung zum Aufnehmen und/oder Transportieren von Substraten nach einem der vorstehenden beiden Ansprüche, **dadurch gekennzeichnet, dass** der Kenndatensatz eine Veränderung des Bewegungsablaufs abhängig von einer Änderung der Anlagenkonfiguration repräsentiert, wobei der Kenndatensatz insbesondere zur Feinanpassung des Bewegungsablaufs verwendbar ist.

22. Vorrichtung zum Aufnehmen und/oder Transportieren von Substraten nach einem der vorstehenden Ansprüche, **dadurch gekennzeichnet, dass** die Vorrichtung Mittel zur Aufnahme und/oder Speicherung zumindest eines Kenndatensatzes umfasst, der die Feinsteuerung eines Bewegungsverlaufs repräsentiert.

23. Vorrichtung zum Aufnehmen und/oder Transportieren von Substraten nach dem vorstehenden Anspruch, **dadurch gekennzeichnet, dass** die Vorrichtung Mittel zur Feinsteuerung des Bewegungsverlaufs unter Einbeziehung einer Position umfasst.

24. Vorrichtung zum Aufnehmen und/oder Transportieren von Substraten nach einem der vorstehenden Ansprüche, **dadurch gekennzeichnet, dass** die Vorrichtung zur Abstandsmessung zumindest einen kapazitiven Sensoren, einen Ultraschallsensor und/oder eine Lichtschranke aufweist.

25. Vorrichtung zum Aufnehmen und/oder Transportieren von Substraten nach einem der vorstehenden Ansprüche, **dadurch gekennzeichnet, dass** die Vorrichtung eine Aufnahmeeinrichtung, vorzugsweise ausgebildet zur Aufnahme zumindest eines Substrats, aufweist, welche zumindest drei, vorzugsweise vier und besonders bevorzugt fünf Sensoren aufweist.

26. Automatisierungseinrichtung, insbesondere zur Verarbeitung von Wafern, umfassend eine Vorrichtung zum Aufnehmen und/oder Transportieren von Substraten nach einem der vorstehenden Ansprüche.
